Europäisches Patentamt

**European Patent Office**

Office européen des brevets

(19)

(11) Numéro de publication : **0 159 208**
**B1**

(12) **FASCICULE DE BREVET EUROPÉEN**

(45) Date de publication du fascicule du brevet :
07.09.88

(51) Int. Cl.⁴ : **H 01 L 23/14**, H 01 L 21/48

(21) Numéro de dépôt : **85400283.9**

(22) Date de dépôt : **18.02.85**

(54) Procédé de fabrication de circuits électroniques de puissance miniaturisés.

(30) Priorité : **28.02.84 FR 8403485**

(43) Date de publication de la demande :
**23.10.85 Bulletin 85/43**

(45) Mention de la délivrance du brevet :
**07.09.88 Bulletin 88/36**

(84) Etats contractants désignés :
**AT DE GB IT**

(56) Documents cités :
**EP-A- 0 015 053**
**EP-A- 0 057 085**
**EP-A- 0 078 582**
**DE-A- 3 330 068**
**FR-A- 2 220 879**
**Le dossier contient des informations techniques présentées postérieurement au dépôt de la demande et ne figurant pas dans le présent fascicule.**

(73) Titulaire : **AUTOMOBILES PEUGEOT**
**75, avenue de la Grande Armée**
**F-75116 Paris (FR)**

**AUTOMOBILES CITROEN**
**62 Boulevard Victor-Hugo**
**F-92200 Neuilly-sur-Seine (FR)**

(72) Inventeur : **Celnik, Jean**
**40, avenue d'Italie**
**F-75013 Paris (FR)**

(74) Mandataire : **Boivin, Claude**
**9, rue Edouard-Charton**
**F-78000 Versailles (FR)**

## Description

La présente invention concerne un procédé de fabrication de circuits électroniques de puissance miniaturisés réalisés par le processus technologique dit S.M.I. (Substram Métallique Isolé) et les circuits miniaturisés obtenus par ce procédé.

Il est important, dans la fabrication électronique des circuits de puissance miniaturisés, de permettre une bonne dissipation de la chaleur du module et, notamment, des éléments de puissance du module lorsqu'ils sont reportés à plat.

L'expérience a montré que les procédés de fabrication connus jusqu'à présent de circuits comportant des éléments de puissance reportés à plat sur le réseau conducteur ne permettent pas d'amener de la soudure sous les composants, donc le report à plat de mini-boîtiers de puissance de façon satisfaisante. Un procédé conforme à celui du préambule de la revendication 1 est connu de EP-A-0 057 085.

La présente invention a pour objet un procédé de fabrication qui remédie à ces inconvénients et permet la réalisation de circuits de puissance miniaturisés, comportant des mini-éléments de puissance reportés à plat sur le réseau conducteur et en contact avec ce dernier par apport de soudure sous le composant, ce qui améliore les échanges thermiques par intégration du radiateur dans le substrat d'interconnexion et assure la dissipation de chaleur du module, ces circuits de puissance étant ensuite montés sans radiateur intermédiaire directement sur le châssis.

Le procédé selon l'invention dans lequel les mini-éléments de puissance sont brasés sur un réseau conducteur reporté avec interposition d'un isolant sur une plaque en métal bon conducteur de la chaleur, est caractérisé par les étapes du procédé de la seconde partie de la revendication 1.

Dans un mode de réalisation avantageux de l'invention, on réalise un substrat dont la surface est un multiple de celle du circuit à réaliser, on réalise une série de circuits identiques sur le substrat, et on découpe ensuite l'ensemble pour obtenir les circuits unitaires.

Le procédé selon l'invention, outre les avantages déjà signalés, permet d'obtenir une importante miniaturisation et une meilleure conductibilité thermique, et améliore la fiabilité par une meilleure reproductivité du processus, l'utilisation de composants modernes et l'introduction en fabrication de phases de contrôle automatiques.

Enfin, il permet un abaissement des coûts unitaires par traitement collectif du produit.

On a décrit ci-après, à titre d'exemple non limitatif, un mode de mise en oeuvre du procédé selon l'invention, avec référence au dessin annexé dans lequel :

La Figure 1 montre une partie d'un substrat après gravure du réseau conducteur ;

La Figure 2 montre, à plus grande échelle, une partie du substrat de la Figure 1 ;

La Figure 3 est une vue semblable à la Figure 2, après mise en place et brasage des composants ;

La Figure 4 est une vue en coupe du substrat selon IV-IV de la Figure 3.

Selon l'invention, pour réaliser un circuit de puissance miniaturisé, on part d'un substrat constitué par une plaque 1 en un métal bon conducteur, par exemple en aluminium, sur laquelle est collée une feuille stratifiée composée d'un film plastique 2 recouverte extérieurement d'une couche de métal bon conducteur 3. La plaque 1 a une épaisseur de l'ordre de 2 à 3 mm. Le film plastique a une faible épaisseur de l'ordre de 25 à 30 microns et est réalisé par exemple en une résine polyimide résistant à haute température, telle que celle connue dans le commerce sous le nom de Kapton. De son côté, la couche de cuivre déposée sur le film plastique a une épaisseur de l'ordre de 35 à 70 microns. La feuille stratifiée est fixée sur la plaque 1 par collage à chaud.

Une série de circuits est formée simultanément sur le substrat. on réalise les divers réseaux de conducteurs tels que 4 à l'aide de la couche 3 en ne laissant subsister que les parties nécessaires de cette couche. On peut par exemple recouvrir la couche d'un film photosensible, insoler à travers un masque représentant les réseaux de conducteurs à former, laver de façon à éliminer les parties non insolées, et attaquer le cuivre mis à nu ; il ne reste plus qu'à éliminer les parties insolées qui recouvrent les connexions 4.

On procède ensuite au dépôt par sérigraphie de pâte à braser aux endroits tels que 5 des connexions 4 qui doivent être brasés à des connexions des composants ainsi qu'aux endroits tels que 5' où un élément de puissance doit être brasé sur le substrat de façon à assurer un transfert des calories dégagées à la plaque 1 formant radiateur.

On dépose les composants à plat sur le substrat de façon que leurs pattes de connexion tels que 6 et 7 soient au contact de la pâte à braser et que les boîtiers des éléments de puissance soient au contact direct du métal de la feuille stratifiée (mise à la Masse). Ces composants peuvent, par exemple, être des transistors de puissance tels que 8, des résistances ou des diodes telles que 9 et 10, ou des circuits intégrés tels que 11. Leur dépôt est réalisé de façon automatique par exemple par une machine du type « Pick and place » propre à permettre le dépôt unitaire de 5.000 à 10.000 composants à l'heure ou par une machine du type « multiplace » qui permet le dépôt collectif et automatique de 30.000 à 50.000 composants à l'heure.

On procède alors au brasage en phase vapeur des pattes de connexion 6 et 7 des composants sur les connexions 4 et au nettoyage. Pour cela, on immerge le substrat avec les composants dans un fluide à l'état de vapeur, par exemple dans un composé organique fluoré, tel que le $(C_5 F_{11})_3 N$. La température de vaporisation du fluide détermine le type de soudure et doit être supérieure de 20° C à la température de fusion de la soudure pour que cette dernière ait de bonnes caractéristiques de fluidité et de mouillabilité.

La vapeur évite l'exposition à l'air des brasures et limite les risques d'oxydation pendant cette phase tout en permettant d'utiliser des alliages de 60 % d'étain et de 40 % de plomb à une température de fusion de 185°.

Cette opération permet aussi de réaliser un brasage sous les composants, c'est-à-dire dans le cas de composants de puissance, de réaliser un brasage entre le radiateur situé sous le composant et le substrat.

On effectue ensuite des tests électriques de chaque fonction du circuit à l'aide d'une machine automatique.

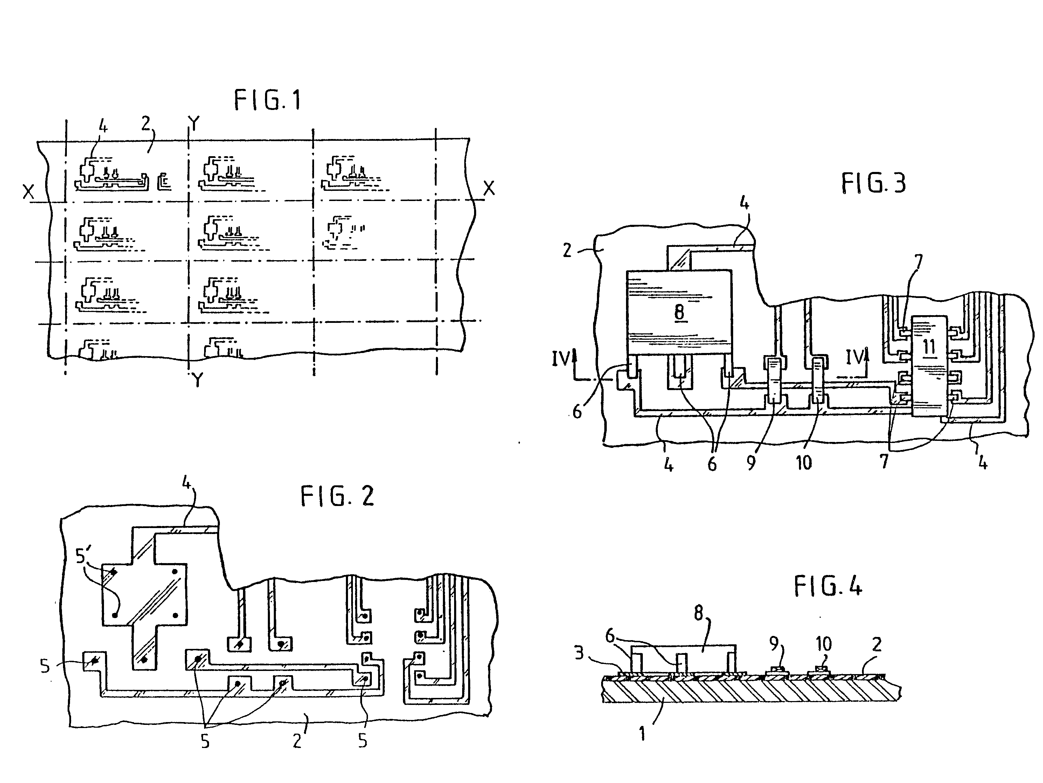

Il ne reste plus qu'à procéder au découpage des différents circuits suivant les lignes telles que X-X et Y-Y à la Figure 1, ce découpage pouvant être effectué à l'aide d'une presse à découper ou par laser, etc... à mettre chacun des circuits séparés dans un boîtier plastique obtenu par injection de matière plastique dans un moule comprenant le connecteur de sortie et les points de fixation du boîtier, et à braser les connexions de sortie.

## Revendications

1. Procédé de fabrication de circuits électroniques de puissance miniaturisés comportant des éléments soudés en phase vapeur sur un réseau conducteur reportés avec interposition d'un isolant sur une plaque en métal bon conducteur de la chaleur, caractérisé en ce qu'on réalise un substrat en collant sur la plaque métallique (1) une feuille stratifiée composée d'un film plastique (2) recouvert extérieurement d'une couche (3) de métal bon conducteur, qu'on forme les réseaux conducteurs (4) à partir de la couche (3) de métal, qu'on dépose de la pâte à braser (5) sur les endroits des connexions (4) devant être brasés à des composants ainsi que sur les endroits (5') où les radiateurs situés sous les composants doivent être brasés sur la couche (3), qu'on pose les composants à plat sur le substrat de façon que leurs pattes de connexion (6 et 7) soient au contact de la pâte à braser et qu'on procède au brasage des connexions en phase vapeur, le circuit obtenu étant ensuite mis dans un boîtier étanche.

2. Procédé selon la revendication 1, caractérisé en ce qu'on réalise un substrat dont la surface est un multiple de celle du circuit à réaliser, qu'on réalise une série de circuits identiques sur le substrat, et qu'on découpe ensuite l'ensemble pour obtenir les circuits unitaires.

3. Procédé selon la revendication 1 ou 2, caractérisé en ce que la couche isolante est constituée d'une résine haute température résistant à une température de l'ordre de 150°.

4. Procédé selon l'une des revendications 1 à 3, caractérisé en ce que l'épaisseur du film est de 25 à 50 micromètres et que la couche de métal est une couche de cuivre de 35 à 70 micromètres.

5. Procédé selon l'une quelconque des revendications précédentes, caractérisé en ce que la formation des connexions (4) est réalisée par attaque chimique.

6. Procédé selon l'une quelconque des revendications précédentes, caractérisé en ce que le brasage en phase vapeur se fait par immersion de la plaque supportant les composants dans une vapeur d'un composé organique fluoré dont la température est supérieure d'environ 20° C à celle de fusion de la soudure.

7. Procédé selon l'une quelconque des revendications précédentes, caractérisé en ce que les circuits sont testés par une machine automatique avant l'opération de découpage.

## Claims

1. A method of manufacturing miniaturized power electronic circuits including elements soldered in the vapor phase to a conducting network laid with interpositioning of an insulating means on a good heating conducting metal plate, characterized in that a substrate is formed by bonding to the metal plate (1) a laminated foil formed of a plastic film (2) coated externally with a good conducting metal layer (3), the conducting networks (1) are formed from the metal layer (3), the brazing paste (5) is deposited at the positions on the conenctions (4) to be brazed to the components as well as at positions (5') where the heat sinks situated under the components are to be brazed to the layer (3), the components are laid flat on the substrate so that their connecting lugs (6 and 7) are in contact with the brazing paste and the connections are brazed in the vapor phase, the circuit obtained then being placed in a sealed chip.

2. Process according to claim 1, characterized in that a substrate is formed whose area is a multiple of that of the circuit to be formed, a series of identical circuits are formed on the substrate then the whole is cut up so as obtain the individual circuits.

3. Process according to claim 1 or 2, characterized in that the insulating layer is formed of a high temperature resin withstanding a temperature of the order of 150°.

4. Process according to one of claims 1 to 3, characterized in that the thickness of the film is 25 to 50 $\mu$m and the metal layer is a copper layer of 35 to 70 $\mu$m.

5. Process according to any one of the preceding claims, characterized in that the formation of the connections (4) is obtained by chemical etching.

6. Process according to any one of the preceding claims, characterized in that the vapor phase brazing is achieved by immersing the plate supporting the components in a vapor of a fluorated organic compound whose temperature is greater by about 20 °C than the melting temperature of the solder.

7. Process according to any one of the preceding claims, characterized in that the circuits are tested by means of an automatic machine before the cutting up operation.

**Patentansprüche**

1. Verfahren zur Herstellung miniaturisierter elektronischer Leistungsschaltkreise mit Schaltelementen, die in einer Dampfphase auf ein Leiternetzwerk aufgelötet worden sind, das unter Zwischenschaltung eines Isolators auf eine Metallplatte, die ein guter Wärmeleiter ist, übertragen worden ist, dadurch gekennzeichnet, daß man ein Substrat herstellt, indem man eine Schichtstoffolie, bestehend aus einem an seiner Außenseite mit einer Schicht (3) aus gut leitendem Metall bedeckten Kunststoffilm (2) auf die Metallplatte (1) aufklebt, daß man die Leiterbahnen (4), ausgehend von der Schicht (3) aus Metall ausbildet, daß man auf die Verbindungsstellen (4), bevor sie mit den Bauelementen verlötet werden und ebenso auf die Stellen (5'), wo die unter den Bauelementen gelegenen Kühlkörper auf die Schicht (3) aufgelötet werden sollen, Lötpaste (5) aufträgt, daß man die Bauelemente derart flach auf das Substrat aufsetzt, daß ihre Verbindungslaschen (6 und 7) im Kontakt mit der Lötpaste sind und daß man das Verlöten der Verbindungen in einer Dampfphase durchführt, wobei der erhaltene Schaltkreis danach in ein dichtes Gehäuse eingesetzt wird.

2. Verfahren nach Anspruch 1, dadurch gekennzeichnet, daß man ein Substrat herstellt, dessen Oberfläche ein Vielfaches der Oberfläche des herzustellenden Schaltkreises beträgt, daß man auf dem Substrat eine Serie identischer Schaltkreise herstellt und daß man danach die Gesamteinheit auseinanderschneidet, um die einzelnen Schaltkreise zu erhalten.

3. Verfahren nach Anspruch 1 oder 2, dadurch gekennzeichnet, daß die isolierende Schicht aus einem hochtemperaturbeständigen Harz besteht, das gegen eine Temperatur in der Größenordnung von 150° beständig ist.

4. Verfahren nach einem der Ansprüche 1 bis 3, dadurch gekennzeichnet, daß die Dicke des Films 25 bis 50 Mikrometer beträgt und daß die Metallschicht eine Kupferschicht mit einer Dicke von 35 bis 70 Mikrometern ist.

5. Verfahren nach einem der vorhergehenden Ansprüche, dadurch gekennzeichnet, daß die Herstellung der Verbindungen (4) durch chemisches Anätzen bewirkt wird.

6. Verfahren nach einem der vorhergehenden Ansprüche, dadurch gekennzeichnet, daß das Verlöten in einer Dampfphase durch Eintauchen der die Bauelemente tragenden Platte in einen Dampf einer organischen Fluorverbindung durchgeführt wird, dessen Temperatur um etwa 20 °C über der Verschmelzungstemperatur der Lötverbindung liegt.

7. Verfahren nach einem der vorhergehenden Ansprüche, dadurch gekennzeichnet, daß die Schaltkreise mittels einer automatischen Vorrichtng vor dem Auseinanderschneiden getestet werden.

FIG.1

FIG.3

FIG.2

FIG.4

0 159 208